# EUROPEAN PATENT SPECIFICATION

(11) **EP 2 963 431 B1**
(45) Date of publication and mention of the grant of the patent: **08.01.2020**
(21) Application number: 13876267.9
(22) Date of filing: 30.09.2013
(51) Int. Cl.: G01R 31/34

(54) **TEST SYSTEM FOR POWER GRID ADAPTABILITY OF MOBILE WIND TURBINE GENERATOR SYSTEM**
TESTSYSTEM FÜR STROMNETZANPASSBARKEIT EINES MOBILEN WINDTURBINENGENERATORSYSTEMS
SYSTÈME DE TEST POUR L'ADAPTABILITÉ AU RÉSEAU ÉLECTRIQUE D'UN SYSTÈME DE GÉNÉRATEUR ÉOLIEN MOBILE

(30) Priority: 27.02.2013 CN 201310060904
(43) Date of publication of application: 06.01.2016
(73) Proprietor: State Grid Corporation of China (SGCC), Beijing 100031 (CN); China Electric Power Research Institute, Beijing 100192 (CN); Cepri Zhangbei Wind Power Research and Test Co. Ltd, Hebei 076450 (CN)
(72) Inventor: WANG, Ruiming, Beijing 100192 (CN); QIN, Shiyao, Beijing 100192 (CN); LI, Shaolin, Beijing 100192 (CN); LI, Qing, Beijing 100192 (CN); WANG, Wei, Beijing 100192 (CN); SUN, Yong, Beijing 100192 (CN); CHEN, Chen, Beijing 100192 (CN)
(74) Representative: Vidon Brevets & Stratégie
(86) International application number: PCT/CN2013/084672
(87) International publication number: WO 2014/131282

(56) References cited:
- WO-A1-2011/160564
- CN-A- 102 129 036
- CN-A- 102 148 501
- CN-A- 103 257 314
- CN-U- 203 164 379
- DE-A1-102008 049 629
- DE-A1-102010 060 333
- US-A1- 2012 139 576

## Description

### FIELD OF THE INVENTION

The invention relates to the new energy access and control field, and particularly to a kind of test system for mobile wind turbines power grid adaptability.

### BACKGROUND OF THE INVENTION

Wind turbine is a multidisciplinary cross technology-intensive product. The weak grid adaptability of power electronic devices makes it highly sensitive to the disturbance. While most of China's wind farms have been constructed in the power grid weak areas, the quality of power grid operation is poor, wherein the wind turbines without parallel operation test can not parallel operate normally and safely. Volatility, intermittent and other natural attributes of the wind power resources with the complexity and grid high sensitivity of the wind turbines decide that the wind the wind turbines parallel test detection must be carried out based on the actual operation, Laboratory simulation or factory test can not accurately fully reflect the real parallel operation characteristics of the wind turbines. Currently the world's major grid guideline all have made different levels of requirements for the wind turbines power grid adaptability, wind turbines have power gird adaptability which have become the inevitable requirement of wind power grid. There is no field test equipment using for wind turbines have power grid adaptability based on the actual operation in domestic and overseas.

### SUMMARY OF THE INVENTION

Document D1 describes a test system for mobile wind turbines power gird adaptability, wherein said system includes the grid turbulence generator and the integrated measurement-control device connected by the optical fiber, wherein said grid turbulence generator is connected between the medium voltage power grid and the wind turbines step-up transformer high voltage side.

Against the deficiency of the existence art, the present invention provides a kind of test system for mobile wind turbines power grid adaptability, which can be online real simulation generates power grid voltage deviation, frequency variation, three-phase voltage unbalance, voltage flicker and common grid disturbances in wind turbines step-up transformer high voltage side, collects and analyzes the real running data of the wind turbines, and makes tests and evaluations for the wind turbines power grid adaptability. The technology solution provided by the present invention would solve the wind turbines power grid adaptability under the condition of complex topography and transportation.

**The present is realized by the technical scheme below:**
According to the present invention, a test system according to claim 1 is provided.

Preferably, said grid turbulence generator is used for online real simulation generating the grid disturbances in wind turbines step-up transformer high voltage side; said integrated measurement-control device is used for collecting electrical quantities and state variables information, real-time analyzing the wind turbines power grid adaptability performance index, at the same time controlling and monitoring the running state of the test system; The grid turbulence generator to integrate with measurement-control device is installed in the container to realize the mobile power grid adaptability test system; Said grid turbulence generator is the medium voltage grid turbulence generator.

Preferably, said low frequency disturbance generator includes sequentially connected step-down transformer, converter link and step-up transformer; the output end of said set-up transformer connects to the high frequency disturbance generator or the medium voltage grid;

Said converter link is in N single phase or three phase AC - DC - AC converter in parallel mode; Said N is between 1-4.

Said high frequency disturbance generator module is in single phase H bridge AC-DC-AC converter cascade mode.

Preferably, said DSP controller includes low frequency disturbance generator DSP controller, high frequency disturbance generator DSP controller;
Said low frequency disturbance generator DSP controller and high frequency disturbance generator DSP controller all connect to the running-into or open-out component through optical fiber; Said low frequency disturbance generator DSP controller and high frequency disturbance generator DSP controller all connect to the communication management machine; Said running-into or open-out component and communication management machine connect to CPU separately through optical fiber;
Said low frequency disturbance generator DSP controller and high frequency disturbance generator DSP controller communicates with the background monitor computer through communication management machine;

Said background monitor computer connects to the communication management machine through bus RS485.

Preferably, said integrated measurement-control device includes A/D converter and electric signal running-into or open-out board;Said A/D converter connects to the CPU through chip selected address signal and data cable respectively; Said running-into or open-out board of the electrical signal connects to the CPU through optical fiber; Setting 3 conditioning board connects to the A/D converter respectively ;Wherein one conditioning board inputs current inputs quantity, another conditioning board inputs voltage collect quantity of the side on wind turbines,the third conditioning board inputs simulation collect quantity except for current and voltage.

The open electrical signal of said electrical signal running-into or open-out board includes fan contactor feedback signal, stroke switch feedback signal and scram open signal; the open-out electrical signal includes fan contactor control signal and fault output signal.

**Compared with the existing art, the advantages of the present invention are described as below:**
(1) The test system for mobile power grid adaptability has high integration. The integration of all the grid turbulence generator, data acquisition system, monitoring system, etc into a GP container, solve the experiment and testing problems of the wind turbines power grid adaptability under the condition of complex topography and transportation, can realize mobile testing, greatly improve the efficiency of test equipment.
(2)The test system for mobile power grid adaptability has high precision. According to the properties of grid disturbance needed to happen, the grid turbulence generator can be divided into low frequency disturbances module and high frequency disturbance module, wherein the low frequency disturbances module generates low frequency power grid disturbance quantity, the high frequency disturbances module generates high frequency power grid disturbance quantity, it greatly improve the output precision of the grid turbulence generator, especially the harmonic voltage has high precision output, and improve the stability of the system.
(3) The test system for mobile power grid adaptability has good ability and high precision of harmonic outputting. Based on the principle of voltage source in series, superimpose the harmonic voltage signal directly to the medium voltage power grid, it simulates the medium voltage power grid harmonic disturbance to solve the influence of the own collector parameter of the testing device on intensity and accuracy of the harmonic outputting.
(4) The test system for mobile power grid adaptability has high degree of automation; all test operation can be realized through the background remote monitoring computer.
(5) The technical solution of present invention bases design scheme on AC - DC - AC alternating technology and low frequency disturbances module with the combination of step-up and step-down transformer. Through the combination of step-up and step-down transformer it realizes the operation of high voltage disturbance produced by AC - DC - AC converter and makes it suitable for medium voltage wind turbines power grid adaptability test; At the same time the adoption of converting technology, isolates the test device form power grid access point completely, to avoid the influence of test device for the grid; Moreover, the parallel operation technology of the converter makes the capacity design and expansion of the test device relatively flexible.

### BRIEF DESCRIPTION OF THE DRAWINGS

Fig. 1 shows structure diagram of the grid turbulence generator provided by the present invention;
Fig. 2 shows structure diagram of the low frequency disturbance generator provided by the present invention;
Fig. 3 shows principle diagram of the high frequency disturbance generator provided by the present invention;
Fig. 4 shows diagram of the integrated measurement-control device of the power grid adaptability test system provided by the present invention;
Fig. 5 shows logic flow chat of the automatic control of the start of low frequency disturbance generator provided by the present invention;
Fig. 6 shows logic flow chat of the automatic control of the start of high frequency disturbance generator provided by the present invention;
Fig. 7 shows logic flow chat of the automatic control of the stop of grid turbulence device provided by the present invention;
Fig. 8 shows layout chart of the mobile of the power grid adaptability test system provided by the present invention;
Fig. 9 shows field test diagram of the power grid adaptability test system provided by the present invention;

### DETAILED DESCRIPTION OF EMBODIMENTS

**The detail of the embodiments is described as below incorporated with the figures by way of cross-reference.**

The test device for mobile power grid adaptability comprises the grid turbulence generator and the integrated measurement-control system. The grid turbulence generator can online real simulation generates common grid disturbances in wind turbines step-up transformer high voltage side; The integrated measurement-control system is used for collecting electrical quantities and state variables information, real-time analyzing the wind turbines power grid adaptability performance index, at the same time controlling and monitoring the running state of the test system. Integration of the above devices can be installed in a standard shipping container to realize the test system for mobile power adaptability.

### 1. The design for grid turbulence generator:

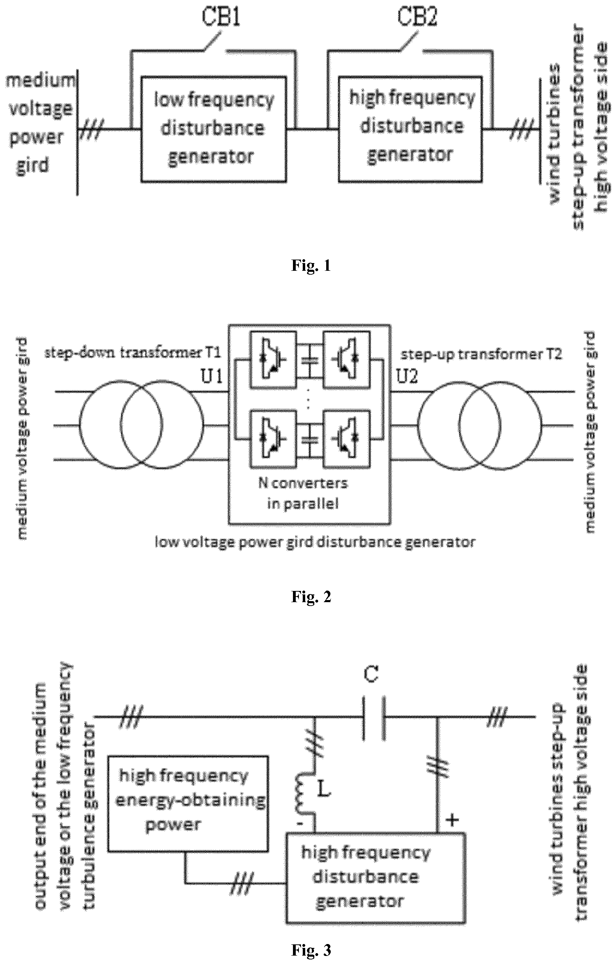

The grid turbulence generator is the core of the power grid adaptability test system, it can simulate all kinds common grid disturbances, applied to the wind turbines power grid adaptability test. The grid turbulence generator is based on the principle of voltage source in series, adopts modularization design, can realize high, low frequency disturbance generator independent or joint operation, its structure diagram is shown as Figure 1. The grid turbulence generator includes the low frequency disturbance generator connected with the medium voltage grid and the high frequency disturbance generator connected with the wind turbines step-up transformer high voltage side; The low frequency disturbance generator and high frequency disturbance generator connected in turn; The low frequency turbulence generator links in parallel with the circuit breaker CB1, the high frequency turbulence generator links in parallel with the circuit breaker CB2.When the circuit breaker CB1 is opened and CB2 is closed, the grid turbulence generator runs in bypass state; When the circuit breaker CB1 is opened,CB2 is closed, the low frequency turbulence generator puts into operation separately, the high frequency turbulence generator runs in bypass; When the circuit breaker CB1 is closed,CB2 is opened, the high frequency turbulence generator puts into operation separately, the low frequency turbulence generator runs in bypass; When the circuit breaker CB1 and CB2 are both opened, the high and low frequency turbulence generator are joint running. This modularization design increases the operational control flexibility of the device, improves the output precision of the high frequency turbulence generator.

### 1.1 The design for low frequency turbulence generator:

The low frequency turbulence generator is based on AC - DC - AC alternating technology, by the combination of AC - DC - AC alternating and transformer ,and the combination of the AC - DC - AC alternating and the step-up and step-down transformer simulation to generate the low frequency disturbance of medium voltage power grid, as shown in Figure 2.The low frequency disturbance generator includes sequentially connected step-down transformer, converter link and step-up transformer; The output end of said set-up transformer connects to the high frequency disturbance generator or the medium voltage grid;

The specific working principle :The medium voltage power grid steps-down to U1 via transformer T1, then invert-outputs the required voltage U2 through the converter link, at last boosts to medium through by boost converter T2.The converter link uses N single phase or three phase AC - DC - AC converter in parallel mode; Said N is between 1-4.Through this kind of structure design, the modulation wave instruction of the inverter side on AC - DC - AC converter side is modified to obtain all kinds of low frequency power grid disturbance waveform which the power gird adaptability test system needed form the medium voltage power grid;

At the same time the adoption of AC - DC - AC converting technology isolates the test device from power grid access point completely, to avoid the influence of test device for the grid. The voltage operation level of the low frequency turbulence generator depends on the transformation ratio of the step-up and step-down transformer, the device operating capacity depends on the capacity and quantity of the parallel converter. The low frequency turbulence generator can generate simulated voltage deviation, undulating frequency, three-phase voltage unbalance, voltage fluctuations and flicker such low frequency power grid disturbance quantities.

### 1.2 The design for low frequency turbulence generator:

In order to improve the output precision of harmonic voltage, simplify the filter design for the low frequency turbulence module, based upon the principle of voltage source in series, high frequency turbulence module is superimposed to the output end accessing to grid or on the low frequency turbulence module to generate the harmonic voltage on the medium voltage power grid, as shown in Fig. 3,the high frequency disturbance generator based upon the principle of voltage source in series, includes high frequency disturbance generator module, high frequency energy-obtaining power connected to a high frequency energy-obtaining power and LC filter circuit; LC filter circuit includes capacitor C and inductance L; Said capacitor C connects to the output end of the medium voltage or the low frequency turbulence generator, said capacitor C connects to the high frequency turbulence generator module via inductance L; The high frequency disturbance generator module uses single phase H bridge AC-DC-AC converter cascade mode, it can also output the higher harmonic voltage through controlling the converter side of the converter link H bridge, that is power grid voltage harmonics and distortion.

### 2. Integrated measurement-control system:

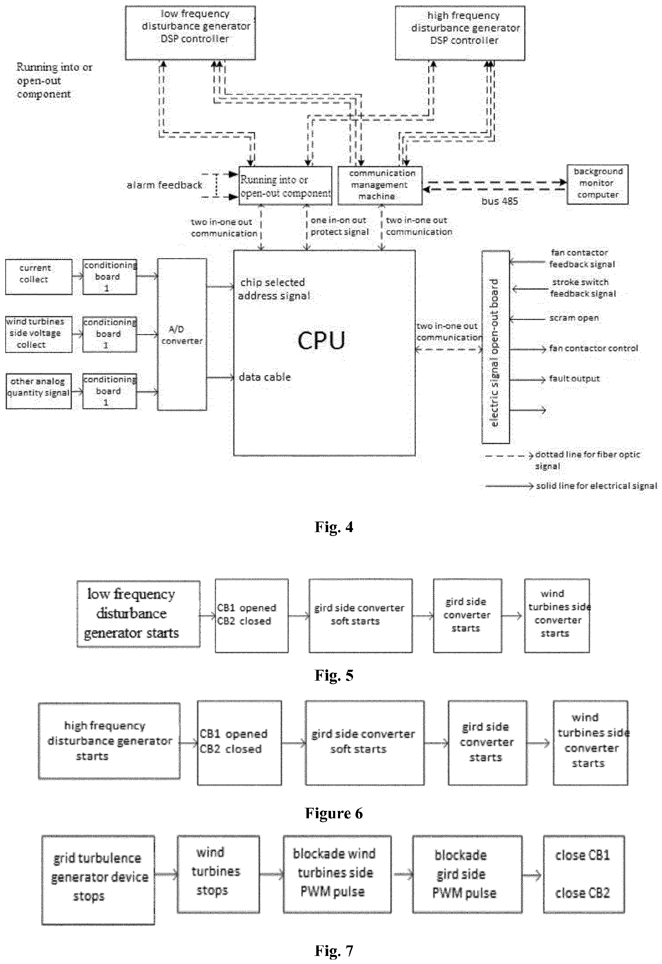

The structure diagram of the power grid adaptability test device measurement-control system is shown as Fig. 4, the power grid adaptability test system is an integration of the mobile wind turbines power grid adaptability controlling, state monitoring, data collecting and analyzing, it includes the CPU, the DSP controller and the background monitoring computer.

As shown in Fig. 4,the CPU is the core processor of test system for the power gird adaptability, It's responsible for collecting, computing and analyzing the relevant electrical quantities and state variables, obtains the control instruction of the background remote computer through the communication management machine, monitors and controls the state of the power grid adaptability measurement-control device.

The CPU takes charge of collecting the module signal of wind turbines at parallel net location such as the three phase voltage, the three phase current and the real-time wind speed to analysis the parallel operation of wind turbines, to calculate the characteristic parameter, and to upload to remote background monitor computer through the communication management machine, the remote background monitor computer reflects the real-time running state of the wind turbines;
DSP controller is the core control processor of the power grid turbulence generator, that is the 32 bit fixed point DPS TMS320F2812 of TI company, is used to collect the relevant electrical quantities and state variables, receives the instruction signal of the communication management machine and to generate expected PWM trigger signal the output disturbance state required.DSP controller communicates with the background computer, it is realized by the communication management machine, the background computer issues orders to the converter DSP controller through the communication management machine, the connection between the converter DSP controller and the communication management machine is by optical fiber, is completely isolated.DSP controller includes low frequency disturbance generator DSP controller and high frequency disturbance generator DSP controller;

The low frequency disturbance generator DSP controller and high frequency disturbance generator DSP controller all connect to the running-into or open-out component through optical fiber; Said low frequency disturbance generator DSP controller and high frequency disturbance generator DSP controller all connect to the communication management machine; Said running-into or open-out component and communication management machine connect to CPU separately through optical fiber; the low frequency disturbance generator DSP controller and high frequency disturbance generator DSP controller communicates with the background monitor computer through communication management machine; the background monitor computer connects to the communication management machine through bus RS485.

The CPU takes charge of monitoring and controlling the state of the whole test progress, cures several important automatic control logic, clicks on the corresponding control icon in the background computer, will perform different automatic logic control. Such as starting the low frequency disturbance device as shown in Fig. 5 - Fig. 7, just click low frequency disturbance device start button in the background computer, the corresponding program starts automatically, if no trouble appears, the device starts automatically without human intervention, to avoid the man-made wrong operation in the process of the whole plant operation.

Integrated measurement-control device includes A/D converter and electric signal running-into or open-out board; Said A/D converter connects to the CPU through chip selected address signal and data cable respectively; said running-into or open-out board of the electrical signal connects to the CPU through optical fiber; setting 3 conditioning board connects to the A/D converter; Wherein one conditioning board inputs current collect quantity, another conditioning board inputs voltage collect quantity of the side on wind turbines, the third conditioning board inputs simulation collect quantity except for current and voltage.

The running-into electrical signal of said electrical signal running-into or open-out board includes fan contactor feedback signal, stroke switch feedback signal and scram open signal; the open out electrical signal includes fan contactor control signal and fault output signal.

### 3. The mobile design:

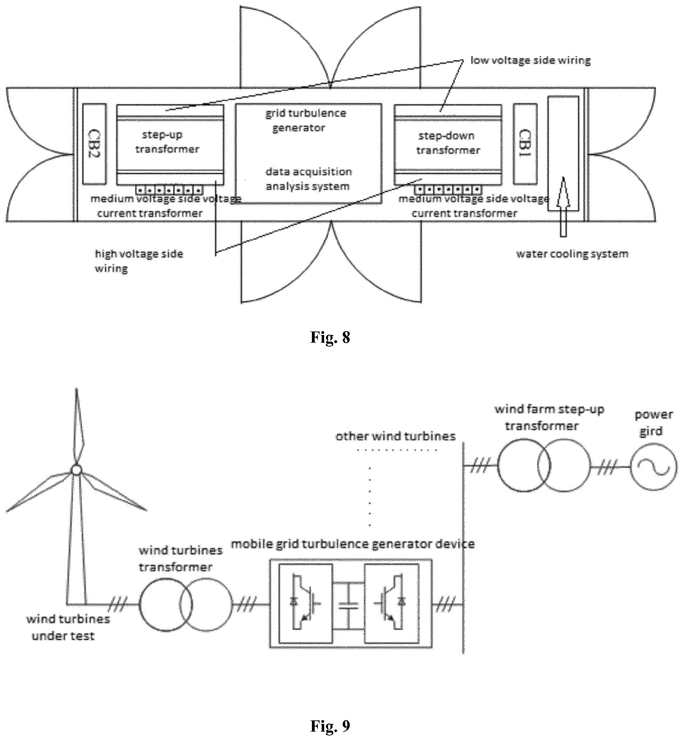

In order to facilitate the experiment and testing of the wind turbines power grid adaptability under the condition of complex topography and transportation, improved the efficiency of the power grid adaptability test device, the integration of the medium voltage power grid is installed in a standard shipping container, of which the structure of the internal installation layout is shown as Fig. 8,the container includes the cooling devices, said cooling devices include the water cooling device and the air cooling device. The insulation of the medium voltage that can realized by insulating material, insulating tape or insulating barrier and pressure-resistant are specifically designed can realize the integration installation in a limited space; the cooling method when the power grid turbulence generator is running is specially designed, completed the intelligent coordination control of the water cooling and the air cooling; the protection grade of the device is specially designed, to satisfy the requirements of the system special operation environment.

### Embodiment

The field test diagram of the power grid adaptability test system is shown as Fig. 9, the cable which connect the wind turbines transformer high voltage side and the medium voltage power grid is disconnected, accesses the medium voltage power grid to the output side of the low frequency turbulence module, then accesses the wind turbines transformer high voltage side to the output side of the high frequency turbulence module, that install the power grid adaptability test device in series between the wind turbines transformer high voltage side and the medium accessing grid

During the test, the start and stop of the power grid turbulence generator and the data collecting system are controlled by the integrated measurement-control system, the output contents of the power grid turbulence generator is controlled by the integrated measurement-control system, thus it can generate simulation power grid voltage deviation, frequency variation, three-phase voltage unbalance, voltage flicker and harmonic such common grid disturbances in wind turbines transformer high voltage side, so that it processes the voltage adaptability test, frequency adaptability test, three-phase voltage unbalance adaptability test, voltage flicker adaptability test and harmonic adaptability test for the wind turbines. Analyzes and evaluates the power grid adaptability of the wind turbines through the relevant test data which collected by the data collecting system (realized by three conditioning board).

## Claims

1. A mobile test system for wind turbines power grid adaptability, wherein said system includes a grid turbulence generator and an integrated measurement-control device, wherein the said grid turbulence generator is connected between a medium voltage power grid and a wind turbines step-up transformer high voltage side; **characterized in that** the grid turbulence generator and the integrated measurement control device are connected with each other by an optical fiber, wherein the grid turbulence generator and the integrated measurement-control device are integrated and installed in a container; wherein said container includes a cooling system inside, said cooling system includes a water cooling device and an air cooling device; wherein said integrated measurement-control device includes:
a CPU that is configured to collect three phase voltage, three phase current and real-time wind speed of a grid connection point of a wind turbines under test as analogue quantities during an analysis of the parallel operation of wind turbines, and to upload them to a remote background monitor computer through a communication management machine, a remote background monitor computer reflecting the real-time running state of the wind turbines;
a DSP controller that is configured to collect the analogue quantities of the grid connection point of the wind turbines under test, configured to receive an instruction signal of the communication management machine, and configured to generate and output the PWM trigger signal with a desired disturbance state;
wherein the DSP controller is configured to communicate with the background monitor computer through the communication management machine;
wherein the background monitor computer is configured to issue instructions to the DSP controller by the communication management machine;
wherein said grid turbulence generator comprises a modularized design that includes a low frequency disturbance generator connected with one end to the medium voltage power grid and with the other end to one end to a high frequency disturbance generator, the other end of the high frequency disturbance generator being connected with the wind turbines step-up transformer high voltage side;
wherein, to each of said low frequency disturbance generator and said high frequency disturbance generator, a respective circuit breaker is connected in parallel,
wherein said high frequency disturbance generator is adapted to superpose a harmonic voltage signal directly on the medium voltage power grid;
wherein said high frequency disturbance generator includes a LC filter circuit, said LC filter circuit includes a capacitor C, wherein one end of the capacitor C is connected to the low frequency turbulence generator, and is further connected via an inductance L to one terminal of the high frequency disturbance generator, wherein the other end of the capacitor C is connected to another terminal of the high frequency disturbance generator.

2. The test system according to claim 1, wherein said grid turbulence generator is configured to be used for online real simulation generating the grid disturbances in wind turbines step-up transformer high voltage side; wherein said integrated measurement-control device is configured to be used for collecting electrical quantities and state variables information, real-time analyzing the wind turbines power grid adaptability performance index, at the same time controlling and monitoring the running state of the test system; wherein the grid turbulence generator and integrated measurement-control device are integrated and is installed in the container to realize the mobile power grid adaptability test system; wherein said grid turbulence generator is the medium voltage grid turbulence generator.

3. The test system according to claim 1, wherein said low frequency disturbance generator includes sequentially connected step-down transformer, converter link and step-up transformer; wherein the output end of said set-up transformer connects to the high frequency disturbance generator or the medium voltage grid;
wherein said converter link uses N single phase or three phase AC - DC - AC converter in parallel mode; said N is between 1-4.

4. The test system according to claim 1, wherein said DSP controller includes low frequency disturbance generator DSP controller and high frequency disturbance generator DSP controller;
Wherein said low frequency disturbance generator DSP controller and high frequency disturbance generator DSP controller all connect to an open-out component through optical fiber; said low frequency disturbance generator DSP controller and high frequency disturbance generator DSP controller all connect to the communication management machine; said open-out component and communication management machine connect to CPU separately through optical fiber;
said low frequency disturbance generator DSP controller and high frequency disturbance generator DSP controller are configured to communicate with the background monitor computer through communication management machine;
said background monitor computer connects to the communication management machine through bus RS485.

5. The test system according to claim 1, wherein said integrated measurement-control device includes A/D converter and electric signal open-out board, wherein said A/D converter is configured to connect to the CPU through chip selected address signal and data cable respectively; said run-into or open-out board of the electrical signal connects to the CPU through optical fiber; setting 3 conditioning board which connects to the A/D converter respectively, wherein one conditioning board inputs current collect quantity, another conditioning board is configured to input voltage collect quantity of the side on wind turbines, the third conditioning board is configured to input simulation collect quantity except for current and voltage,
the open electrical signal of said electrical signal open-out board includes fan contactor feedback signal, stroke switch feedback signal and scram open signal; the open-out electrical signal includes fan contactor control signal and fault output signal.

## Patentansprüche

1. Mobiles Testsystem für die Anpassungsfähigkeit von Windturbinen an das Stromnetz, wobei das System einen Netzturbulenzgenerator und eine integrierte Messsteuerungsvorrichtung umfasst, wobei der Netzturbulenzgenerator zwischen einem Mittelspannungsnetz und einer Aufwärtstransformator-Hochspannungsseite für Windturbinen verbunden ist; **dadurch gekennzeichnet, dass** der Netzturbulenzgenerator und die integrierte Messsteuerungsvorrichtung miteinander durch eine optische Faser verbunden sind, wobei der Netzturbulenzgenerator und das integrierte Messsteuerungssystem in einem Container integriert und installiert sind; wobei der Container im Inneren ein Kühlungssystem umfasst, wobei das Kühlungssystem eine Wasserkühlungsvorrichtung und eine Luftkühlungsvorrichtung umfasst; wobei das integrierte Messsteuerungssystem umfasst: ein CPU, das konfiguriert ist, um Dreiphasenspannung, Dreiphasenstrom und die Echtzeitwindgeschwindigkeit eines Netzverbindungspunktes einer getesteten Windturbine als analoge Mengen während einer Analyse des parallelen Betriebs von Windturbinen zu verbinden und sie auf einen Computer mit Remote Background Monitor durch eine Kommunikationsmanagementmaschine hochzuladen, wobei ein Computer mit Remote Background Monitor den Echtzeitlaufzustand der Windturbinen wiederspiegelt; eine DSP Steuerung, welche dafür konfiguriert ist, die analogen Mengen des Netzverbindungspunktes der getesteten Windturbinen zu sammeln, welche dafür konfiguriert sind, um ein Befehlssignal der Kommunikationsmanagementmaschine zu empfangen und dafür konfiguriert sind, um das PWM Triggersignal mit einem gewünschten Störungszustand zu erzeugen und auszugeben; wobei die DSP Steuerung dafür konfiguriert ist, mit dem Computer mit Background Monitor durch die Kommunikationsmanagementmaschine zu kommunizieren; wobei der Computer mit Background Monitor dafür konfiguriert ist, um Befehle an die DSP Steuerung durch die Kommunikationsmanagementmaschine auszugeben; wobei der Netzturbulenzgenerator ein modularisiertes Design umfasst, welches einen Niedrigfrequenz-Störungsgenerator umfasst, der mit einem Ende mit dem Mittelspannungsnetz und mit dem anderen Ende an einem Ende eines Hochfrequenz-Störungsgenerators verbunden ist, wobei das andere Ende des Hochfrequenz-Störungsgenerators mit der Aufwärtstransformator-Hochspannungsseite der Windturbinen verbunden ist; wobei sowohl zu dem Niedrigfrequenz-Störungsgenerator und dem Hochfrequenz-Störungsgenerator ein jeweiliger Leitungsschutzschalter parallel geschaltet ist, wobei der Hochfrequenz-Störungsgenerator daran angepasst ist, ein harmonisches Spannungssignal direkt auf dem Mittelspannungsnetz zu überlagern; wobei der Hochfrequenz-Störungsgenerator eine LC Filterschaltung umfasst, wobei die LC Filterschaltung einen Kondensator C umfasst, wobei ein Ende des Kondensators C mit dem Niedrigfrequenz-Turbulenzgenerator verbunden ist und ferner über eine Induktivität L mit einem Anschlussstück des Hochfrequenz-Störungsgenerators verbunden ist, wobei das andere Ende des Kondensators C mit einem anderen Anschlussstück des Hochfrequenz-Störungsgenerators verbunden ist.

2. Testsystem nach Anspruch 1, wobei der Netzturbulenzgenerator dafür konfiguriert ist, für Online-Real-Simulation verwendet zu werden, wodurch die Netzstörungen in der Aufwärtstransformator-Hochspannungsseite von Windturbinen erzeugt werden; wobei die integrierte Messsteuerungsvorrichtung dafür konfiguriert ist, für das Sammeln von Informationen über elektrischen Mengen und Zustandsvariablen verwendet zu werden, den Leistungsindex für die Anpassungsfähigkeit der Windturbinen an das Stromnetz in Echtzeit zu analysieren, zur selben Zeit den Laufzustand des Testsystems zu steuern und zu überwachen; wobei der Netzturbulenzgenerator und die integrierte Messsteuerungsvorrichtung im Behälter integriert und installiert sind, um das Testsystem für die mobile Anpassungsfähigkeit an das Stromnetz auszuführen; wobei der Netzturbulenzgenerator der Mittelspannungsnetz-Turbulenzgenerator ist.

3. Testsystem nach Anspruch 1, wobei der Niedrigfrequenz-Störungsgenerator einen hintereinander geschalteten Abwärtstransformator, eine Konverterverbindung und einen Aufwärtstransformator umfasst; wobei sich das Ausgabeende des Aufwärtstransformators mit dem Hochfrequenz-Störungsgenerator oder dem Mittelspannungsnetz verbindet; wobei die Konverterverbindung parallel einen N-Einzelphasen- oder Dreiphasen- AC - DC - AC Konverter verwendet; wobei N zwischen 1-4 liegt.

4. Testsystem nach Anspruch 1, wobei die DSP-Steuerung eine Niedrigfrequenz-Störungsgenerator DSP Steuerung und Hochfrequenz-Störungsgenerator DSP Steuerung umfasst; wobei die Niedrigfrequenz-Störungsgenerator DSP Steuerung und die Hochfrequenz-Störungsgenerator DSP Steuerung alle durch eine optische Faser mit einer sich nach außen öffnenden Komponente verbunden sind; wobei sich die Niedrigfrequenz-Störungsgenerator DSP Steuerung und die Hochfrequenz-Störungsgenerator DSP Steuerung alle mit der Kommunikationsmanagementmaschine verbinden; wobei sich die nach außen öffnende Komponente und die Kommunikationsmanagementmaschine separat mit dem CPU durch eine optische Faser verbinden; wobei die Niedrigfrequenz-Störungsgenerator DSP Steuerung und die Hochfrequenz-Störungsgenerator DSP Steuerung dafür konfiguriert sind, mit dem Computer mit Background Monitor durch eine Kommunikationsmanagementmaschine zu kommunizieren; wobei sich der Computer mit Background Monitor durch den RS485 Bus mit der Kommunikationsmanagementmaschine verbindet.

5. Testsystem nach Anspruch 1, wobei die integrierte Messsteuerungsvorrichtung einen A/D Konverter und ein sich nach außen öffnendes elektrisches Signal Bord umfasst, wobei der A/D Konverter dafür konfiguriert ist, um sich jeweils mit dem CPU durch ein durch einen Chip ausgewähltes Adresssignal und Datenkabel zu verbinden; sich das hineinlaufende und sich nach außen öffnende Bord des elektrischen Signals durch eine optische Faser mit dem CPU verbindet; ein Setting 3 Konditionierungsbord, welches sich jeweils mit dem A/D Konverter verbindet, wobei ein Konditionierungsbord die Stromsammlungsmenge eingibt, ein anderes Konditionierungsbord dafür konfiguriert ist, die Spannungssammlungsmenge der Seite an Windturbinen einzugeben, das dritte Konditionierungsbord dafür konfiguriert ist, die Simulationssammlungsmenge mit Ausnahme von Strom und Spannung einzugeben, das offene elektrische Signal des elektrischen sich nach außen öffnenden Signal Bords ein Ventilator Schaltschütz Rückmeldungssignal, ein Taktschalter-Rückmedlungssignal und ein Schnellabschaltungsöffnungssignal umfasst; wobei sich das nach außen öffnende elektrische Signal ein Ventilator Schaltschütz Steuerungssignal und Fehlerausgabesignal umfasst.

## Revendications

1. Système mobile de test d'adaptabilité au réseau électrique d'éoliennes, dans lequel ledit système inclut un générateur de turbulence de réseau et un dispositif de contrôle de mesure intégré dans lequel ledit générateur de turbulence de réseau est connecté entre un réseau électrique moyenne tension et un côté haute tension de transformateur élévateur d'éoliennes ;
**caractérisé en ce que** le générateur de turbulence de réseau et le dispositif de contrôle de mesure intégré sont connectés l'un à l'autre par une fibre optique, dans lequel le générateur de turbulence de réseau et le dispositif de contrôle de mesure intégré sont intégrés et installés dans un contenant ; dans lequel ledit contenant inclut un système de refroidissement à l'intérieur, ledit système de refroidissement inclut un dispositif de refroidissement par eau et un dispositif de refroidissement par air ;
dans lequel ledit dispositif de contrôle de mesure intégré inclut :
une UC qui est configurée pour collecter une tension triphasée, un courant triphasé et une vitesse de vent en temps réel d'un point de connexion au réseau d'éoliennes à tester en tant que quantités analogiques pendant une analyse du fonctionnement parallèle d'éoliennes, et pour les téléverser vers un ordinateur de surveillance d'arrière-plan distant par le biais d'une machine de gestion de communication, un ordinateur de surveillance d'arrière-plan distant reflétant l'état de marche en temps réel des éoliennes ;
un contrôleur DSP qui est configuré pour collecter les quantités analogiques du point de connexion au réseau des éoliennes à tester, configuré pour recevoir un signal d'instructions de la machine de gestion de communication, et configuré pour générer et fournir en sortie le signal de déclenchement PWM avec un état de perturbation souhaité ;
dans lequel le contrôleur DSP est configuré pour communiquer avec l'ordinateur de surveillance d'arrière-plan par le biais de la machine de gestion de communication ;
dans lequel l'ordinateur de surveillance d'arrière-plan est configuré pour émettre des instructions à destination du contrôleur DSP par la machine de gestion de communication ;
dans lequel ledit générateur de turbulence de réseau comprend une conception modularisée qui inclut un générateur de perturbation basse fréquence connecté à une extrémité au réseau électrique moyenne tension et à l'autre extrémité à une extrémité à un générateur de perturbation haute fréquence, l'autre extrémité du générateur de perturbation haute fréquence étant connectée au côté haute tension de transformateur élévateur d'éoliennes ;
dans lequel, à chacun dudit générateur de perturbation basse fréquence et dudit générateur de perturbation haute fréquence, un disjoncteur respectif est connecté en parallèle,
dans lequel ledit générateur de perturbation haute fréquence est adapté pour superposer un signal de tension harmonique directement sur le réseau électrique moyenne tension ;
dans lequel ledit générateur de perturbation haute fréquence inclut un circuit de filtre LC, ledit circuit de filtre LC inclut un condensateur C, dans lequel une extrémité du condensateur C est connectée au générateur de turbulence basse fréquence, et est en outre connectée via une inductance L à une borne du générateur de perturbation haute fréquence, dans lequel l'autre extrémité du condensateur C est connectée à une autre borne du générateur de perturbation haute fréquence.

2. Système de test selon la revendication 1, dans lequel ledit générateur de turbulence de réseau est configuré pour être utilisé pour une simulation réelle en ligne générant les perturbations de réseau dans un côté haute tension de transformateur élévateur d'éoliennes ; dans lequel ledit dispositif de contrôle de mesure intégré est configuré pour être utilisé pour collecter des quantités électriques et des informations de variables d'état, analyser en temps réel l'indice de performance d'adaptabilité au réseau électrique d'éoliennes, dans le même temps commander et surveiller l'état de marche du système de test ; dans lequel le générateur de turbulence de réseau et le dispositif de contrôle de mesure intégré sont intégrés et sont installés dans le contenant pour matérialiser le système de test d'adaptabilité au réseau électrique mobile ; dans lequel ledit générateur de turbulence de réseau est le générateur de turbulence de réseau moyenne tension.

3. Système de test selon la revendication 1, dans lequel ledit générateur de perturbation basse fréquence inclut un transformateur abaisseur, un lien de convertisseur et un transformateur élévateur connectés séquentiellement ; dans lequel l'extrémité de sortie dudit transformateur élévateur se connecte au générateur de perturbation haute fréquence ou au réseau moyenne tension ;
dans lequel ledit lien de convertisseur utilise N convertisseurs CA-CC-CA monophasés ou triphasés en mode parallèle ; ledit N est compris entre 1 et 4.

4. Système de test selon la revendication 1, dans lequel ledit contrôleur DSP inclut un contrôleur DSP de générateur de perturbation basse fréquence et un contrôleur DSP de générateur de perturbation haute fréquence ;
dans lequel ledit contrôleur DSP de générateur de perturbation basse fréquence et ledit contrôleur DSP de générateur de perturbation haute fréquence se connectent tous à un composant d'ouverture par le biais d'une fibre optique ; ledit contrôleur DSP de générateur de perturbation basse fréquence et ledit contrôleur DSP de générateur de perturbation haute fréquence se connectent tous à la machine de gestion de communication ; ledit composant d'ouverture et ladite machine de gestion de communication se connectent à l'UC séparément par le biais d'une fibre optique ;
ledit contrôleur DSP de générateur de perturbation basse fréquence et ledit contrôleur DSP de générateur de perturbation haute fréquence sont configurés pour communiquer avec l'ordinateur de surveillance d'arrière-plan par le biais d'une machine de gestion de communication ;
ledit ordinateur de surveillance d'arrière-plan se connecte à la machine de gestion de communication par le biais d'un bus RS485.

5. Système de test selon la revendication 1, dans lequel ledit dispositif de contrôle de mesure intégré inclut un convertisseur A/N et une carte d'ouverture de signal électrique,
dans lequel ledit convertisseur A/N est configuré pour se connecter à l'UC par le biais d'un signal d'adresse sélectionné par puce et d'un câble de données respectivement ; ladite carte d'introduction ou d'ouverture du signal électrique se connecte à l'UC par le biais d'une fibre optique ; réglant 3 cartes de conditionnement qui se connectent au convertisseur A/N respectivement, dans lequel une carte de conditionnement fournit en entrée une quantité de collecte de courant, une autre carte de conditionnement est configurée pour fournir en entrée une quantité de collecte de tension sur le côté des éoliennes, la troisième carte de conditionnement est configurée pour fournir en entrée une quantité de collecte de simulation à l'exception du courant et de la tension,
le signal électrique ouvert de ladite carte d'ouverture de signal électrique inclut un signal de rétroaction de contacteur de ventilateur, un signal de rétroaction de commutateur de course et un signal d'ouverture d'urgence ; le signal électrique d'ouverture inclut un signal de commande de contacteur de ventilateur et un signal de sortie de défaut.
